# EUROPEAN PATENT SPECIFICATION

(11) **EP 1 918 801 B1**
(45) Date of publication and mention of the grant of the patent: **18.08.2010**
(21) Application number: 06425755.3
(22) Date of filing: 06.11.2006
(51) Int. Cl.: G06F 1/20, H01L 23/34, H05K 7/20

(54) **Integrated circuit electronic device comprising an improved cooling system**
Elektronische integrierte Schaltvorrichtung mit verbessertem Kühlsystem
Dispositif électronique à circuit intégré comprenant un système de refroidissement amélioré

(43) Date of publication of application: 07.05.2008
(73) Proprietor: Magneti Marelli S.p.A., Corbetta (MI) (IT)
(72) Inventor: Rosada, Claudio, Corbetta (Milano) (IT); Bonello Fabrizio, Corbetta (Milano) (IT); Campinoti, Daniele, Corbetta (Milano) (IT)
(74) Representative: Cerbaro, Elena

(56) References cited:
- US-A- 5 963 424
- US-A1- 2005 046 802
- US-B1- 6 215 659

## Description

The present invention relates to an integrated circuit electronic device comprising an improved cooling system, specifically a vehicle satellite navigator.

As it is known, integrated circuit electronic devices, such as, for example, motherboards, are equipped with electronic components which often develop large quantities of heat, under intense work loads. This is due both to the increasingly high operating frequencies of the electronic components, which require higher quantities of current, and to the increasingly small dimensions of the casings which contain the electronic components, which tend to make the temperature increase inside the casing.

An electronic component which operates at high temperatures works in a stressed situation which may cause execution errors of the functions implemented by the component and damage the component.

Therefore, in order to prevent the temperature of the electronic components from exceeding the threshold values beyond which the electronic components may be damaged, it is known to cool the electronic components with specific cooling systems such as, for example, passive type air cooling systems and active type air cooling systems.

The integrated circuit electronic devices are usually provided with passive type air cooling systems, are prevalently used for cooling electronic components which develop low quantities of heat, such as for example chipsets, RAMs, GPUs, etc., and consist of a metallic dissipater (usually formed by copper or aluminium) fixed to the electronic component by means of clips or heat-conducting glues. The heat produced by the electronic component is transmitted by conduction to the metal of the dissipater which disposes of the heat into the environment by convection.

Active air cooling systems, instead, comprise an electrical fan which forces the air directly either onto the electronic components to be cooled or onto the dissipater so as to increase the convection and consequently the heat exchange between the dissipater and the surrounding environment. Fans are mostly used to cool CPUs, chipsets and GPUs.

The cooling systems of the known type are generally designed to eliminate the hot air from within the case which contains the electronic components of the electronic device but are not capable of appropriately cooling each electronic component according to its heat features and accounting for its position within the case with respect to the position of the fan. This implies a non always optimal cooling of the single electronic components of the device, which may cause the failure of the same.

Specifically, in a satellite navigator, the components which require an efficient cooling are the logical components carried by the daughterboard and the power audio amplifier.

US 2005/046802 discloses an electronic apparatus housed in a dual housing structure that includes an inner case housing electronics and an outer case surrounding the inner case. The inner and outer cases have respective intake openings, and in the area where the respective intake openings are provided, the inner and outer cases are spaced from each other by a sufficient distance such that an intake chamber is defined between the inner and outer cases. The intake opening of the inner case and the intake opening of the outer case are displaced from each other with respect to a front-and-rear direction of the apparatus so as to provide a nonlinear intake passage. Projecting lens is provided centrally in a front end section of the apparatus. Fan unit is provided, to the left or right of the lens, for discharging exhaust air from within the apparatus, and a silencer is provided, to the right or left of the lens, for silencing the exhaust air discharged via the fan unit. Duct connects between the fan unit and the silencer while bypassing the underside or upside of the projecting lens to have an increased overall length. Also, in the portion bypassing the lens, the duct has a reduced height but an increased depth to make up for the reduced height in such a manner that the duct has a substantially uniform sectional area throughout its length to avoid an increase in resistance to the exhaust. At least three mounting portions are formed on the front and rear surfaces of the fan unit, and the at least three mounting portions are attached to a fan case via gel-state shock absorbers.

It is the object of the present invention to make a cooling system of an integrated circuit electronic device, specifically for a vehicle navigator, free from the drawbacks described above.

According to the present invention, it is made a cooling system of an integrated circuit electronic device, and specifically for a navigator, as defined in claim 1.

For a better understanding of the present invention, a preferred embodiment will now be described only by way of non-limitative example, and with reference to the accompanying drawings, in which:
- figure 1 is a perspective view with parts removed for clarity of an integrated circuit electronic device, a vehicle navigator in the case in point, provided with the cooling system of the invention;
- figure 2 is a magnified view of a part of the electronic device in figure 1 not in scale; and
- figure 3 is a plan view of the different configurations which a component of the electronic device according to the invention may display.

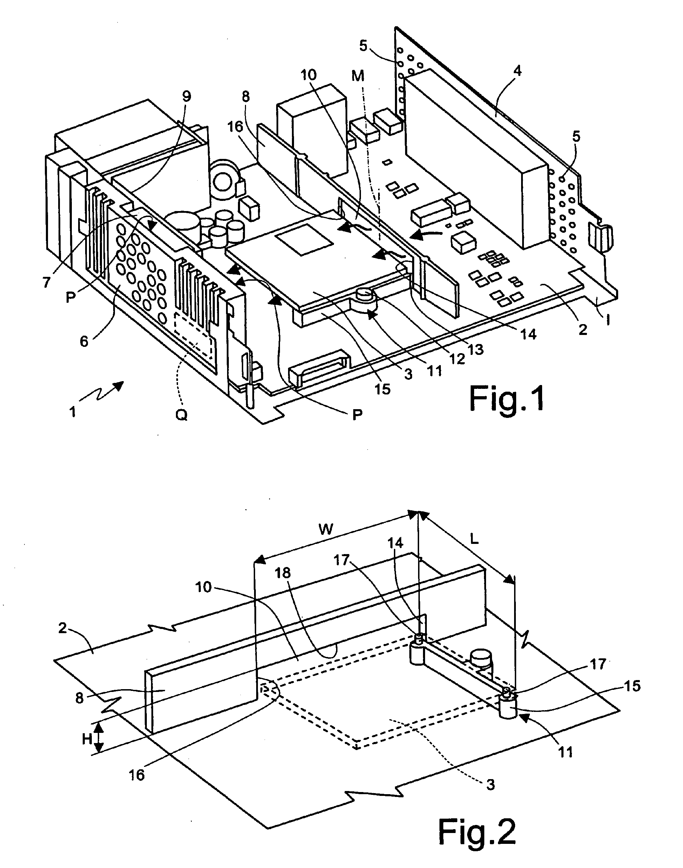

Figure 1 shows an electronic device 1 with parts removed for clarity comprising a boxed casing I (only partially shown), an essentially rectangular motherboard 2 accommodated in casing I, a daughterboard 3 supported by motherboard 2 and a side wall 4 of casing I presenting ventilation grids 5.

Device 1 is further provided with a cooling system comprising a radiating element 6 formed by a metallic material to improve heat dissipation, an electrical fan 7 to generate an air flow lapping on the electrical components of device 1 and a conveying wall 8 to guide the air flow generated by means of fan 7.

Preferably, radiating element 6 defines an external wall of device 1 and is supported by casing I in a counterpoised position with respect to side wall 4.

Preferably, moreover, both fan 7 and an electronic component particularly subject to overheating, such as a power amplifier *Q*, whose position within casing 1 is schematically shown in figure 1, are mounted so as to be directly in contact with corresponding flat faces P of radiating element 6 facing side wall 4. In this manner, the transmission of heat from amplifier *Q* occurs by direct contact and is more efficient. Furthermore, the entire air flow generated by fan 7 interacts with radiating element 6 and air leakages are avoided.

Preferably, both fan 7 and amplifier *Q* are pressed against radiating element 6 by a wall having a portion 9 parallel to faces P and arranged on opposite side of radiating element 6 with respect to fan 7. Portion 9 is connected to radiating element 6 by means of externally adjustable screws to allow the adjustment of the position of portion 9 without needing to open device 1.

Conveying wall 8 is arranged on motherboard 2 within casing I in an intermediate position between fan 7 and side wall 4 along a direction D perpendicular to faces P.

Conveying wall 8 defines a window 10 having a middle line M preferably facing fan 7. Motherboard 3 is arranged between window 10 and fan 7 along direction D and is further supported in a suspended manner with respect to motherboard 2.

Specifically, conveying wall 8 is integral with a straight wall 12 fixed to motherboard 2 by means of a screw 12 and defining with conveying wall 8 a 90° angle.

Preferably, wall 12 presents a length L essentially equal to the width W of window 10 and is connected to conveying wall 8 by means of a weakened portion 13 having a lower thickness with respect to that of conveying wall 8.

Specifically, the weakened portion 13 defines a hinge axis adjacent to a side edge 14 of window 10 to allow the definition of a plurality of possible angular positions of wall 12 with respect to conveying wall 8.

Preferably, conveying wall 8 and support 11 formed by moulding of a polymeric plastic material so that wall 12 is parallel to conveying wall 8 and is connected to the latter by means of the weakened portion 13 and a second weakened portion 13a carried by an end portion 15 longitudinally opposite to weakened portion 13.

During the assembly of conveying wall 8, a cut is made at one of the weakened portions to allow to 'open' wall 12 with respect to conveying wall 8.

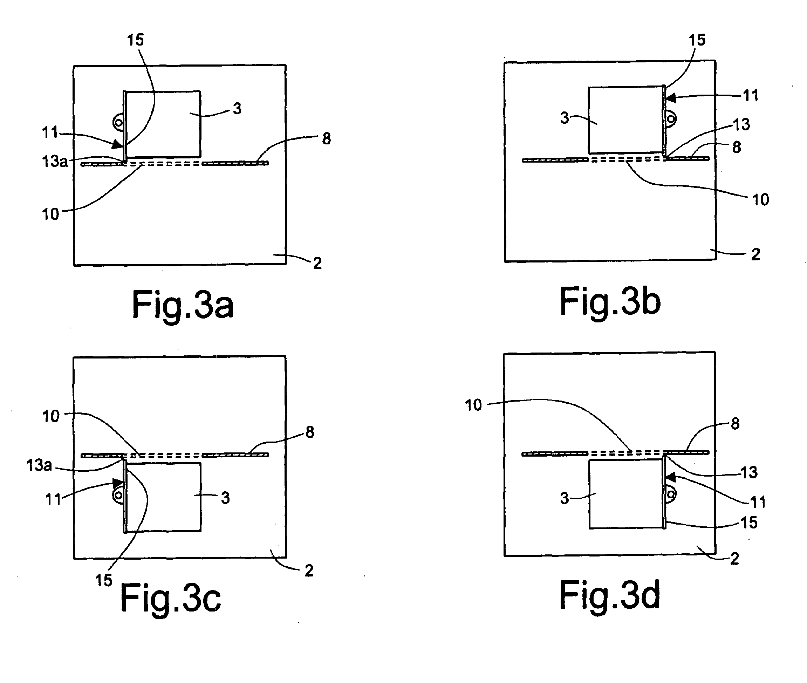

Therefore, according to the layout requirements of motherboard 2, wall 12 may also be hinged about an axis adjacent to a side edge 16 opposite to side edge 14 and assume all the positions shown in figure 3.

Figure 2 shows a connection method of daughterboard 3 onto wall 12.

Specifically, wall 12 comprises a pair of pins 17 which are coupled into respective holes so that daughterboard 3 is protrudingly carried by wall 12.

Preferably, daughterboard 3 displays a dimension essentially equal to the width of window 10 and measured perpendicularly to direction D when daughterboard 3 is mounted on wall 12.

Preferably, moreover, daughterboard 3 is maintained by wall 12 at a lower height with respect to height H of window 10 measured from motherboard 2.

Furthermore, the height and the width of conveying wall 8 are dimensioned so as to define a chamber which encloses daughterboard 3 and a chamber delimited by grids 5 when casing I is closed by means of a lid and two side walls (not shown). Specifically, the height and the width of conveying wall 8 are such that either the chamber containing daughterboard 3 is sealed with respect to the chamber delimited by grids 5 except for window 10, or the gaps defined between conveying wall 8 and the side walls and the lid define an overall resistance to the introduction of air higher than that of window 10. In this manner, when fan 7 is running, most of the air flow directed from grids 5 of radiating element 6 is made to cross window 10 and therefore cool daughterboard 3.

The operation of electronic device 1 is as follows.

When fan 7 is running, the air flow follows the path shown by the arrows in figure 1 and crosses window 10 without being dispersed in other zones of device 1. After crossing window 10, the air flow is split because daughterboard 3 is suspended with respect to motherboard 2 and part of the flow crosses the passage defined between motherboard 2 and daughterboard 3.

The heated air flow after passing over and under daughterboard 3 is finally expelled by fan 7.

The advantages that the electronic device 1 made according to the present invention allows to obtain are apparent from an examination of its features.

Specifically, conveying wall 8 allows to direct the air flow circulating within device 1 onto daughterboard 3 so as to make the cooling more efficient being equal the power of fan 7. Therefore, device 1 is particular adapted to have a compact configuration, as required, for example, in vehicle satellite navigators.

Furthermore, by means of the weakened portion 13, wall 12 may assume several configurations to adapt to layouts of different electronic devices without requiring a dedicated dimensioning and therefore without requiring a dedicated mould and equipment for each device.

The fact that daughterboard 3 is suspended with respect to motherboard 2 allows the introduction of the air flow onto the two most extended faces of the daughterboard 3 in order to increase heat exchange efficiency.

It is finally apparent that changes and variations can be made to the electronic device here described and illustrated without however departing from the scope of protection of the present invention, as defined in the accompanying claims.

## Claims

1. An electronic device (1) comprising a casing (I), a fan (7) for generating a cooling air flow and at least one electronic component (3) generating a quantity of heat to be dissipated, a conveying wall (8) at least partially defining a window (10) and arranged within said casing (I) so that said electronic component (3) is arranged between said window (10) and said fan (7) along the path followed by said air flow from said window (10) to said fan (7), and a support (2) which carries said conveying wall (8);
**characterised in that** said electronic component (3) is suspended with respect to said support (2) by means of a wall (11) so that said airflow also crosses the passage defined between said support (2) and said electronic component (3), whereby said wall (11) is connected to said conveying wall (8) by means of a weakened portion (13; 13a) which defines a hinge axis adjacent to a side edge (14) of said window (10) to allow the definition of a plurality of angular positions of said wall (11) with respect to said conveying wall (8).

2. An electronic device according to claim 1, **characterised in that** said electronic component (3) is suspended with respect to said support (2) so that said air flow also crosses the passage defined between said support (2) and said electronic component (3).

3. A device according to claim 2, **characterised in that** said wall (11) presents a length (L) either equal to or smaller than the longitudinal dimension (W) of said window (10).

4. A device according to any of the claims from 1 to 3, **characterised in that** said support (2) is a motherboard, and **in that** said electronic component (3) is a daughterboard.

5. A device according to any of the preceding claims, **characterised in that** said conveying wall (8) is made of polymeric material by moulding.

6. A device according to any of the preceding claims, **characterised in that** it comprises a radiating element (6), and **in that** said fan (7) is arranged in contact with said radiating element (6).

7. A device according to claim 6, **characterised in that** it comprises at least one second electronic component arranged in contact with said radiating element (6).

8. A device according to claim 7, **characterised in that** it comprises a connection element (9) to maintain said second electronic component in contact against said radiating element (6).

## Patentansprüche

1. Elektronische Vorrichtung (1), mit einem Gehäuse (I), einem Lüfter (7) zum Erzeugen eines Kühlluftstromes und mit mindestens einem elektronischen Bauteil (3), das eine Menge an abzuführender Wärme erzeugt, mit einer Fortleitungswand (8), die zumindest teilweise ein Fenster (10) begrenzt und innerhalb des Gehäuses (I) angeordnet ist, so dass das elektronische Bauteil (3) zwischen dem Fenster (10) und dem Lüfter (7) längs des Pfades angeordnet ist, dem der Luftstrom vom Fenster (10) zum Lüfter (7) folgt, und mit einem Halter (2), der die Fortleitungswand (8) trägt,
**dadurch gekennzeichnet, dass** das elektronische Bauteil (3) hinsichtlich des Halters (2) mittels einer Wand (11) hängend gehalten ist, so dass der Luftstrom auch den Durchgang kreuzt, der zwischen dem Halter (2) und dem elektronischen Bauteil (3) definiert ist, wobei die Wand (11) mit der Fortleitungswand (8) mittels eines schwächer gemachten Bereichs (13; 13a) verbunden ist, der eine Schwenkachse nahe einer Seitenkante (14) des Fensters (10) bildet, um das Bilden einer Vielzahl winkliger Positionen der Wand (11) gegenüber der Fortleitungswand (8) zu ermöglichen.

2. Elektronische Vorrichtung nach Anspruch 1, **dadurch gekennzeichnet, dass** das elektronische Bauteil (3) relativ zum Halter (2) hängend befestigt ist, so dass der Luftstrom auch den Durchgang kreuzt, der zwischen dem Halter (2) und dem elektronischen Bauteil (3) gebildet ist.

3. Vorrichtung nach Anspruch 2, **dadurch gekennzeichnet, dass** die Wand (11) eine Längs (L) aufweist, die gleich oder kleiner als die Längsabmessung (W) des Fensters (10) ist.

4. Vorrichtung nach einem der Ansprüche 1 bis 3, **dadurch gekennzeichnet, dass** der Halter (2) eine Mutterplatine ist und dass das elektronische Bauteil (3) eine Tochterplatine ist.

5. Vorrichtung nach einem der vorhergehenden Ansprüche, **dadurch gekennzeichnet, dass** die Fortleitungswand (8) durch Gießformen aus Polymermaterial hergestellt ist.

6. Vorrichtung nach einem der vorhergehenden Ansprüche, **dadurch gekennzeichnet, dass** sie ein Radiatorelement (6) aufweist und dass der Lüfter (7) in Kontakt mit dem Radiatorelement (6) angeordnet ist.

7. Vorrichtung nach Anspruch 6, **dadurch gekennzeichnet, dass** sie zumindest ein zweites elektronisches Bauteil aufweist, das mit dem Radiatorelement (6) in Kontakt ist.

8. Vorrichtung nach Anspruch 7, **dadurch gekennzeichnet, dass** sie ein Verbindungselement (9) aufweist, um das zweite elektronische Bauteil in Kontakt mit dem Radiatorelement (6) zu halten.

## Revendications

1. Dispositif électronique (1) comprenant un boîtier (I), un ventilateur (7) pour générer un flux d'air de refroidissement et au moins un composant électronique (3) générant une quantité de chaleur à dissiper, une paroi de conduction (8) définissant au moins partiellement une fenêtre (10) et disposée à l'intérieur dudit boîtier (I) de façon telle que ledit composant électronique (3) est agencé entre ladite fenêtre (10) et ledit ventilateur (7) le long de la trajectoire suivie par ledit flux d'air de ladite fenêtre (10) audit ventilateur (7), et un support (2) qui porte ladite paroi de conduction (8);
**caractérisé en ce que** ledit composant électronique (3) est suspendu par rapport audit support (2) au moyen d'une paroi (11) de telle sorte que ledit flux d'air traverse également le passage défini entre ledit support (2) et ledit composant électronique (3), ladite paroi (11) étant reliée à ladite paroi de conduction (8) au moyen d'une partie affaiblie (13; 13a) qui définit un axe d'articulation adjacent à un bord latéral (14) de ladite fenêtre (10) pour permettre la définition d'une pluralité de positions angulaires de ladite paroi (11) par rapport à ladite paroi de conduction (8).

2. Dispositif électronique selon la revendication 1, **caractérisé en ce que** ledit composant électronique (3) est suspendu par rapport audit support (2) de telle sorte que ledit flux d'air traverse également le passage défini entre ledit support (2) et ledit composant électronique (3).

3. Dispositif selon la revendication 2, **caractérisé en ce que** ladite paroi (11) présente une longueur (L) qui est égale à ou plus petite que la dimension longitudinale (W) de ladite fenêtre (10).

4. Dispositif selon l'une quelconque des revendications 1 à 3, **caractérisé en ce que** ledit support (2) est une carte mère, et **en ce que** ledit composant électronique (3) est une carte fille.

5. Dispositif selon l'une quelconque des revendications précédentes, **caractérisé en ce que** ladite paroi de conduction (8) est réalisée en matériau polymère par moulage.

6. Dispositif selon l'une quelconque des revendications précédentes, **caractérisé en ce qu'**il comprend un élément rayonnant (6), et **en ce que** ledit ventilateur (7) est disposé en contact avec ledit élément rayonnant (6).

7. Dispositif selon la revendication 6, **caractérisé en ce qu'**il comprend au moins un second composant électronique disposé en contact avec ledit élément rayonnant (6).

8. Dispositif selon la revendication 7, **caractérisé en ce qu'**il comprend un élément de connexion (9) pour maintenir ledit second composant électronique en contact contre ledit élément rayonnant (6).
